# FASCICULE DE BREVET EUROPEEN

(11) **EP 4 445 161 B1**
(45) Date de publication et mention de la délivrance du brevet: **04.02.2026**
(21) Numéro de dépôt: 22834554.2
(22) Date de dépôt: 08.12.2022
(51) Int. Cl.: G01R 33/38, G01R 33/44, G01R 33/383

(54) **DISPOSITIF D'IMAGERIE PAR RÉSONNANCE MAGNÉTIQUE POURVU D'UN ASSEMBLAGE MAGNÉTIQUE**
APPARAT ZUR BILDERZEUGUNG MITTELS MAGNETISCHER RESONANZ MIT EINER MAGNETISCHEN ANORDNUNG
MAGNETIC RESONANCE IMAGING APPARATUS PROVIDED WITH A MAGNETIC ASSEMBLY

(30) Priorité: 10.12.2021 FR 2113329
(43) Date de publication de la demande: 16.10.2024
(73) Titulaire: Multiwave Technologies AG, 1228 Plan les Ouates - Genève (CH)
(72) Inventeur: ANDIA VERA, Gianfranco, 13013 MARSEILLE (FR); CABON, Chloé, 13013 MARSEILLE (FR); FEZARI, Fouad, 13013 MARSEILLE (FR); BERRAHOU, Djamel, 13013 MARSEILLE (FR); DUBOIS, Marc, 13013 MARSEILLE (FR); ANTONAKAKIS, Tryfon, 13013 MARSEILLE (FR)
(74) Mandataire: IP Trust
(86) Numéro de dépôt international: PCT/EP2022/084933
(87) Numéro de publication internationale: WO 2023/104948

(56) Documents cités:
- CN-A- 113 640 723
- CN-U- 209 884 145
- US-A1- 2015 335 261
- US-A1- 2019 101 607

## Description

### DOMAINE DE L'INVENTION

La présente invention se rapporte au domaine de l'imagerie par résonance magnétique. Plus particulièrement, la présente invention concerne un dispositif d'imagerie par résonance magnétique, et notamment un dispositif d'imagerie par résonance magnétique pourvu d'un assemblage magnétique susceptible d'imposer un champ magnétique principal dans une zone d'analyse.

### ARRIERE PLAN TECHNOLOGIQUE DE L'INVENTION

L'imagerie par résonance magnétique (IRM) est aujourd'hui largement mise en œuvre pour imager, de manière non invasive, l'intérieur de corps et notamment de corps humains. En particulier, l'imagerie par résonance magnétique permet de sonder les noyaux d'hydrogène, et notamment leur spin nucléaire, des molécules d'eau formant pour partie le corps.

A cet égard, un dispositif IRM est pourvu d'un aimant destiné à imposer au corps un champ magnétique statique (dit « champ magnétique principal »), sous l'effet duquel, les spins nucléaires associés aux noyaux d'hydrogène contenus dans les molécules d'eau formant pour partie ce corps se polarisent.

Notamment, les moments magnétiques associés à ces spins s'alignent préférentiellement selon un axe, dit axe z, déterminé par l'orientation du champ magnétique principal de manière à créer une magnétisation du corps.

Un dispositif IRM comprend également des bobines à gradient configurées pour produire des champs magnétiques de petite amplitude et variant dans l'espace lorsqu'un courant leur est appliqué. Plus particulièrement, les bobines à gradient sont conçues pour produire une composante de champ magnétique qui est alignée parallèlement au champ magnétique principal, et qui varie linéairement en amplitude avec la position le long de l'un des axes x, y ou z (les axes x, y et z étant perpendiculaires deux à deux).

Ainsi, les effets combinés des champ magnétiques imposés par les bobines à gradient permettent de coder spatialement chacune des positions du corps destiné à être sondé.

Un dispositif IRM comprend également au moins une bobine radiofréquence (RF) destinée à jouer un rôle d'émetteur récepteur RF. Notamment, l'au moins une bobine radiofréquence est configurée pour émettre des impulsions d'énergie RF d'une fréquence égale ou voisine de la fréquence de résonance des spins des noyaux d'hydrogène et qui est au moins en partie absorbée par ces noyaux.

Dès lors que l'émission RF est interrompue, les spins nucléaires relaxent afin de retrouver leur état d'énergie initial et émettent à leur tour un signal RF susceptible d'être collecté par au moins une bobine RF. Ce signal RF est ensuite traité à l'aide d'un ordinateur et d'algorithmes de reconstruction afin d'obtenir une image du corps.

Le champ magnétique principal, généralement compris entre 1,5 Tesla et 3 Tesla, permet d'atteindre des rapports de signal sur bruit relativement raisonnables et par voie de conséquence de former des images du corps humain d'une qualité suffisante et sur des durée de l'ordre de la minute ou plus.

Toutefois, il est des circonstances pour lesquelles il n'est pas possible de mettre en œuvre un champ magnétique principal d'une telle intensité. Les dispositifs IRM portables en sont un exemple. Ces derniers comprennent en général un aimant permanent ou des électro-aimants d'une capacité limitée, et ne peuvent imposer un champ magnétique principal d'une intensité supérieure à 60 mT, voire supérieure à 200 mT, sans pénaliser la masse ou l'encombrement du dispositif IRM considéré.

Cette limitation en termes d'intensité de champ magnétique principal affecte directement les performances du dispositif IRM. L'amélioration de l'uniformité du champ magnétique principal peut donc être primordiale.

Un but de la présente invention est de proposer un dispositif d'imagerie par résonnance magnétique permettant l'analyse de différentes parties du corps quelles que soit leur taille sans pour autant dégrader la qualité des images susceptibles d'être obtenues sur ces différentes parties de corps.

Un but de la présente invention est de proposer un dispositif d'imagerie par résonnance magnétique, avantageusement mettant en œuvre un champ magnétique principal de faible intensité, pourvu d'un assemblage magnétique dont l'uniformité du champ magnétique créé se trouve améliorée au regard des assemblages connus de l'état de la technique.

Le document US 2019/101607 A1 divulgue un système d'IRM à faible champ mobile et convertible ayant une configuration repliée facilitant le transport et le stockage du système lorsqu'il n'est pas utilisé. Le système convertible comprend une première section, comprenant diverses unités de commande, qui peut être glissée dans une deuxième section et rétractée de celle-ci lors de la transformation du système de sa configuration de transport à sa configuration de fonctionnement. La seconde partie comprend les composants magnétiques définissant la zone d'imagerie, et est configurée pour supporter un patient humain et permettre de le faire pénétrer dans la zone d'imagerie et de l'en faire sortir.

### BREVE DESCRIPTION DE L'INVENTION

Le but de l'invention est atteint par un dispositif d'imagerie par résonnance magnétique qui comprend :
- au un moins un premier module, chaque premier module parmi l'au moins un premier module comprenant un chariot pourvu d'un plateau sur une face duquel, dite face supérieure, repose un assemblage magnétique ledit assemblage magnétique étant destiné à imposer un champ magnétique principal dans une zone d'analyse d'un logement principal dudit assemblage magnétique, le chariot comprenant en outre deux parois latérales supportant par un de leur bord, dit bord supérieur
- un deuxième module, pourvu d'une console, de forme essentiellement parallélépipédique, supportant un ensemble d'éléments de contrôles électroniques dudit dispositif, la console est notamment configurée pour être insérée, par une liaison glissière, entre les parois latérales du chariot de chaque premier module parmi l'au moins un premier module ;
l'un et l'autre de la console et de l'au moins un premier module comprennent des moyens d'identification, par la console, des caractéristiques géométriques et magnétiques de l'assemblage magnétique dudit premier module, les moyens d'identification étant intégrés dans des moyens de connexion de la console et du premier module.

Selon un mode de mise en œuvre, l'assemblage magnétique comprend :
- une pluralité de plaques support présentant chacune une section annulaire délimitant une ouverture, dite ouverture support, lesdites plaques support étant assemblées solidairement les unes des autres, par des moyens d'alignement, selon un axe principal, de sorte que les ouvertures support, alignées selon l'axe principal, délimitent un logement principal de forme généralement cylindrique, chaque plaque support comprend en outre une première pluralité d'aimants permanents, logés dans des premiers logements ménagés dans la section annulaire, selon au moins un agencement annulaire de Halbach autour de l'axe principal, l'ensemble des aimants de la première pluralité d'aimant créant un champ magnétique primaire dans une zone, dite zone d'analyse, du logement principal qui présente une première uniformité ;
- une pluralité de pièces annulaires assemblées coaxialement aux sections annulaires, et solidaires des plaques support, chaque pièce annulaire comprenant une deuxième pluralité d'aimants logées dans des deuxièmes logements ménagés dans ladite pièce annulaire, l'ensemble des pièces annulaires étant agencées de manière à créer un champ magnétique secondaire dans la zone d'analyse de sorte que la résultante du champ magnétique primaire et du champ magnétique secondaire, dite champ principal, dans la zone d'analyse, présente une deuxième uniformité améliorée au regard de la première uniformité.

Selon un mode de mise en œuvre, l'assemblage magnétique comprend une partie principale intercalée entre deux parties secondaires, la partie principale étant formée de plaques support, dites plaques support principales, et l'une et l'autre des parties secondaires étant formées de plaques support dites plaques support secondaires, l'ouverture des plaques support principales, dite première ouverture, présente un premier diamètre, tandis que l'ouverture des plaques support secondaires, dite deuxième ouverture, présente un deuxième diamètre inférieur au premier diamètre.

Selon un mode de mise en œuvre, les plaques support comprennent un matériau non magnétique, avantageusement, le matériau non-magnétique comprend de l'aluminium, une matière plastique, par exemple du plexiglas PMMA.

Selon un mode de mise en œuvre, les moyens d'alignement comprennent des tiges filetées essentiellement parallèles à l'axe principal et maintenant solidaires les unes des autres les plaques support.

Selon un mode de mise en œuvre, chaque plaque support se trouve enserrée entre deux plaques de recouvrement par des moyens de serrage, les deux plaques de recouvrement étant configurées pour retenir les aimants de la première pluralité d'aimants dans les premières cavités de la plaque support considérée, les moyens de serrage comprenant avantageusement des écrous coopérant avec les tiges filetées.

Selon un mode de mise en œuvre, chaque plaque support comprend une ouverture, dite ouverture d'alignement, de sorte que l'assemblage magnétique comprennent au moins un passage d'alignement de section carrée ou rectangulaire formé par les ouvertures d'alignement et qui s'étend parallèlement à l'axe principal, l'assemblage magnétique comprend en outre au moins une tube d'alignement traversant le passage d'alignement, et présentant une forme conforme à la section dudit passage, ledit au moins un tube d'alignement étant destiné à fixer l'assemblage magnétique à un chariot.

Selon un mode de mise en œuvre, chaque plaque support comprend une première plaque et une deuxième plaque assemblée l'une contre l'autre par une face de contact, les premiers logements comprenant chacun deux cavités formées à partir de la face de contact de l'une et/ou l'autre de la première plaque et de la deuxième plaque.

Selon un mode de mise en œuvre, les moyens d'alignement comprennent au moins un rail pourvu d'encoches d'alignement, chaque encoche d'alignement maintenant une plaque support, les encoches étant configurés pour maintenir un espacement prédéterminé en deux plaques support adjacentes.

Selon un mode de mise en œuvre, les moyens d'alignement comprennent un élément d'alignement pourvu d'une embase surmontée d'un berceau formant une portion de cylindre sur une surface interne de laquelle sont formées des gorges, chacune des plaques support étant maintenue dans une gorge qui lui est propre.

Selon un mode de mise en œuvre, chacune plaque support comprend une languette externe qui s'étend radialement à la section annulaire et qui est insérée dans une cavité formée au fond de la gorge maintenant ladite plaque support.

Selon un mode de mise en œuvre, les pièces annulaires sont maintenues entre elles et la pluralité de plaques support par des tiges filetées, dites tiges filetées auxiliaires.

Selon un mode de mise en œuvre, les plaques support comprennent des languettes internes ou externes dans lesquelles sont formés des logements susceptibles de loger un ou plusieurs aimants permanents.

Selon un mode de mise en œuvre, les pièces annulaires sont disposées dans le logement principal.

Selon un mode de mise en œuvre, les pièces annulaires sont disposées extérieurement au logement principal, chaque pièce annulaire est intercalée entre deux plaques support.

Selon un mode de mise en œuvre, ledit assemblage magnétique comprend en outre une bobine radiofréquence et des bobines à gradients disposées dans le logement principal et mécaniquement solidaires de l'assemblage magnétique.

Selon un mode de mise en œuvre, la bobine radiofréquence et les bobines à gradients sont démontables.

### Brève description des dessins

D'autres caractéristiques et avantages de l'invention ressortiront de la description détaillée qui va suivre en référence aux figures annexées sur lesquelles :
[Fig.1] La [Fig.1] est une photographie d'un assemblage magnétique d'un dispositif d'imagerie selon un premier mode de réalisation de la présente invention ;
[Fig.2] La [Fig.2] est une photographie d'une plaque support susceptible d'être mise en œuvre dans le cadre du premier mode de réalisation de la présente invention ;
[Fig.3] La [Fig.3] est une vue en coupe selon un plan de coupe passant par l'axe principal de l'assemblage magnétique selon une première variante du premier mode de réalisation de la présente invention ;
[Fig.4] La [Fig.4] est une vue en coupe selon un plan de coupe passant par l'axe principal de l'assemblage magnétique selon une deuxième variante du premier mode de réalisation de la présente invention ;
[Fig.5] La [Fig.5] est un grossissement de la photographie de la [Fig.1] ;
[Fig.6] La [Fig.6] est une photographie d'un chariot susceptible d'être mis en œuvre dans le cadre de la présente invention ;
[Fig.7] La [Fig.7] est une représentation d'une pièce annulaire susceptible d'être mise en œuvre dans le cadre de la présente invention ;
[Fig.8] La [Fig.8] est représentation schématique, selon une vue de profil (vue perpendiculaire à une face principale), d'une plaque support selon un deuxième mode de réalisation de la présente invention ;
[Fig.9] La [Fig.9] est une vue selon un plan de coupe d'un premier logement selon le deuxième mode de réalisation de la présente invention ;
[Fig.10] La [Fig.10] est une illustration d'un moyen d'alignement formé par un rail selon une vue en perspective ;
[Fig.11] La [Fig.11] est une vue selon un plan de coupe perpendiculaire à l'axe principal AA' de l'assemblage magnétique pourvu de moyens d'alignement formés par 8 rails ;
[Fig.12] La [Fig.12] est une illustration d'un moyen d'alignement formé par un berceau selon une vue en perspective ;
[Fig.13] La [Fig.13] est une illustration d'un assemblage magnétique pourvu d'une bobine RF et de bobines à gradient ;
[Fig.14] La [Fig.14] est une illustration du premier module et du deuxième module ;
[Fig.15] La [Fig.15] est une représentation schématique de la fiche mâle et de la fiche femelle ;
[Fig.16] La [Fig.16] est une autre représentation schématique de la fiche mâle et de la fiche femelle.

### DESCRIPTION DETAILLEE DE L'INVENTION

L'invention concerne un dispositif d'imagerie par résonnance magnétique qui comprend :
- au un moins un premier module, chaque premier module parmi l'au moins un premier module comprenant un chariot pourvu d'un plateau sur une face duquel, dite face supérieure, repose un assemblage magnétique ledit assemblage magnétique étant destiné à imposer un champ magnétique principal dans une zone d'analyse d'un logement principal dudit assemblage magnétique, le chariot comprenant en outre deux parois latérales supportant par un de leur bord, dit bord supérieur
- un deuxième module, pourvu d'une console, de forme essentiellement parallélépipédique, supportant un ensemble d'éléments de contrôles électroniques dudit dispositif, la console est notamment configurée pour être insérée, par une liaison glissière, entre les parois latérales du chariot de chaque premier module parmi l'au moins un premier module ;
l'un et l'autre de la console et de l'au moins un premier module comprennent des moyens d'identification, par la console, des caractéristiques géométriques et magnétiques de l'assemblage magnétique dudit premier module par la console, les moyens d'identification étant intégrés dans des moyens de connexion de la console et du premier module.

L'assemblage magnétique est notamment destiné à imposer, à un corps, un champ magnétique statique, sous l'effet duquel, les spins nucléaires associés aux noyaux d'hydrogène contenus dans les molécules d'eau formant pour partie ce corps se polarisent.

Notamment, l'assemblage magnétique comprend une pluralité de plaques support présentant chacune une section annulaire délimitant une ouverture, dite ouverture support. Plus particulièrement, les plaques support sont assemblées solidairement les unes des autres, par des moyens d'alignement, selon un axe principal, de sorte que les ouvertures support, alignées selon l'axe principal, délimitent un logement principal de forme généralement cylindrique. Chaque plaque support comprend en outre une première pluralité d'aimants permanents, logés dans des premiers logements ménagés dans la section annulaire, selon au moins un agencement annulaire de Halbach autour de l'axe principal. L'ensemble des plaques support est notamment agencé pour créer un champ magnétique primaire dans une zone, dite zone d'analyse, du logement principal qui présente une première uniformité.

L'assemblage magnétique comprend également des pièces annulaires disposées coaxialement aux sections annulaires et solidaires des plaques support. Chaque pièce annulaire comprend une deuxième pluralité d'aimants logées dans des deuxièmes logements ménagés dans ladite pièce annulaire. Les pièces annulaires sont, à cet égard, agencées de manière à créer un champ magnétique secondaire dans la zone d'analyse de sorte que la résultante du champ magnétique primaire et du champ magnétique secondaire, dite champ principal, dans la zone d'analyse, présente une deuxième uniformité améliorée au regard de la première uniformité.

Il est entendu, selon les termes de la présente invention, que la zone d'analyse comprend une section centrale du logement principal. Il est également entendu que la zone d'analyse est au moins délimitée par les deux pièces annulaires positionnées aux deux extrémités, selon l'axe principal, de l'ensemble formé par les pièces annulaires.

Par « uniformité d'un champ magnétique », on entend une variation spatiale de champ magnétique dans la zone d'analyse. Selon la présente invention, la variation spatiale du champ magnétique peut notamment être caractérisée par la différence entre le champ magnétique maximum et le champ magnétique minimum observés dans la zone d'analyse. Ainsi, selon les principes de la présente invention, plus cette différence est faible, meilleure est l'uniformité.

Le caractère modulaire du dispositif d'imagerie selon la présente invention permet de considérer différents premiers modules, chaque premier module étant adapté pour l'analyse d'une section particulière d'un corps. Notamment, il peut être considéré un premier module pour l'analyse du crâne et un autre premier module adapté pour l'analyse d'un membre, notamment d'une jambe.

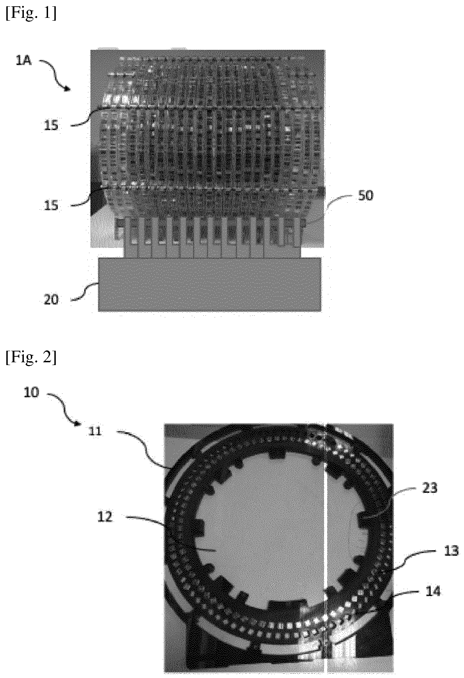

A la [Fig.1], on peut voir un assemblage magnétique 1A d'un dispositif d'imagerie 1 (non représenté) par résonnance magnétique conforme à un premier mode de réalisation de la présente invention.

L'assemblage magnétique 1A comprend notamment une pluralité de plaques support 10. Chaque plaque support 10 est de forme généralement plane et comprend deux faces principales essentiellement parallèles entre elles. Une plaque support 10 peut comprendre un matériau non-magnétique, et notamment de l'aluminium, ou une matière plastique, par exemple du plexiglas PMMA.

Tel que représentée à la [Fig.2], une plaque support 10 comprend une section annulaire 11 qui délimite une ouverture, dite ouverture support 12, débouchant sur chacune des deux faces principales.

La plaque support 12 comprend également une pluralité d'ouvertures traversantes, débouchant également sur chacune des deux faces principales, et formant des logements, dits premiers logements 14. Plus particulièrement, les premiers logements 14 sont formés sur la section annulaire 11 de la plaque support 10 considérée. Notamment, et tel qu'illustré à la [Fig.2], les premiers logements 14 sont agencés sous forme de deux anneaux concentriques.

L'assemblage magnétique 1A comprend également une première pluralité d'aimants permanents 13. Le choix de ces aimants est laissé à l'appréciation de l'homme du métier.

Les aimants 13 sont notamment logés de manière individuelle dans les premiers logements afin de former un agencement annulaire de Halbach. Plus particulièrement, toujours en référence à la [Fig.2], l'agencement annulaire de Halbach comprend deux séries d'aimants 13 formant deux anneaux concentriques. L'invention ne doit toutefois pas être limitée à ce seul aspect, et l'homme du métier pourra considérer un nombre différent d'anneaux.

Selon la présente invention, les plaques support 10 sont assemblées solidairement les unes des autres, par des moyens d'alignement. Plus particulièrement, les plaques supports 10 sont assemblées de sorte que chaque plaque support 10 ait une de ses faces principales en regard d'une face principale d'une plaque support 10 qui lui est directement adjacente. Par ailleurs, un espacement E peut être imposé entre deux plaques support adjacentes.

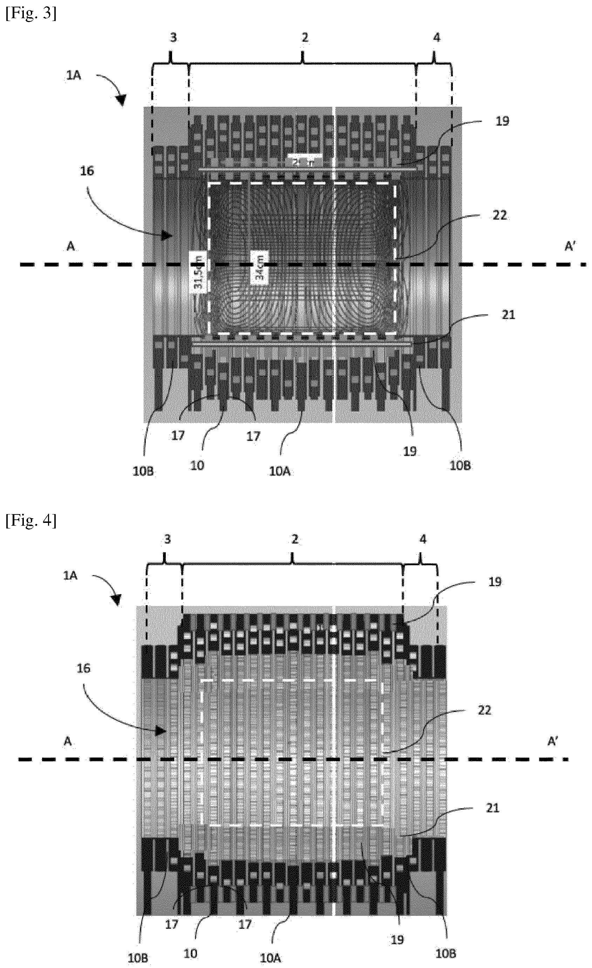

Selon cette configuration, les sections annulaires 11 délimitent un logement, dit logement principal 16, de forme généralement cylindrique autour d'un axe principal AA' ([Fig.3]). Plus particulièrement, les ouvertures support 12 sont alignées, et parallèlement les unes aux autres, selon l'axe principal AA', de manière à former le logement principal 16.

L'ensemble des aimants de la première pluralité d'aimants 13, selon des agencements annulaires de Halbach, créent un champ magnétique primaire dans une zone, dite zone d'analyse, du logement principal qui présente une première uniformité.

Toujours selon ce premier mode de réalisation, l'assemblage magnétique 1A comprend également des plaques de recouvrement 17 de forme généralement plane et qui comprennent également une ouverture, dite ouverture de recouvrement, qui peut être circulaire.

En particulier, chaque plaque support 10 est associée à deux plaques de recouvrement 17 qui lui sont propres. Notamment, chaque plaque support 10 est enserrée entre deux plaques de recouvrement 17. Plus particulièrement, les plaques de recouvrement 17, lorsqu'elles enserrent une plaque support 10 donnée, sont configurées pour retenir les aimants 13 dans les premiers logements 14 de la plaque support 10 considérée.

Les plaques de recouvrement 17 peuvent comprendre un matériau non-magnétique, et notamment de l'aluminium, ou une matière plastique, par exemple du plexiglas PMMA.

Il est entendu, sans qu'il soit nécessaire de le préciser, que l'ouverture de recouvrement présente une forme et des dimensions qui sont semblables à celles de l'ouverture principale. En d'autres termes, la forme et les dimensions de l'ouverture de recouvrement ne remettent pas en cause la définition du logement principal tel que considéré dans la présente invention.

L'assemblage magnétique 1A peut comprendre une partie principale 2 intercalée entre deux parties secondaires 3 et 4 ([Fig.3]). A cet égard, la partie principale 2 est formée par des plaques support 11, dites plaques support principales 11A, tandis que l'une et l'autre des parties secondaires 3 et 4 sont formées de plaques support 11 dites plaques support secondaires 11B. Plus particulièrement, l'ouverture 12 des plaques support principales 11A, dite première ouverture, présente un premier diamètre, tandis que l'ouverture 12 des plaques support secondaires 11B, dite deuxième ouverture, présente un deuxième diamètre inférieur au premier diamètre.

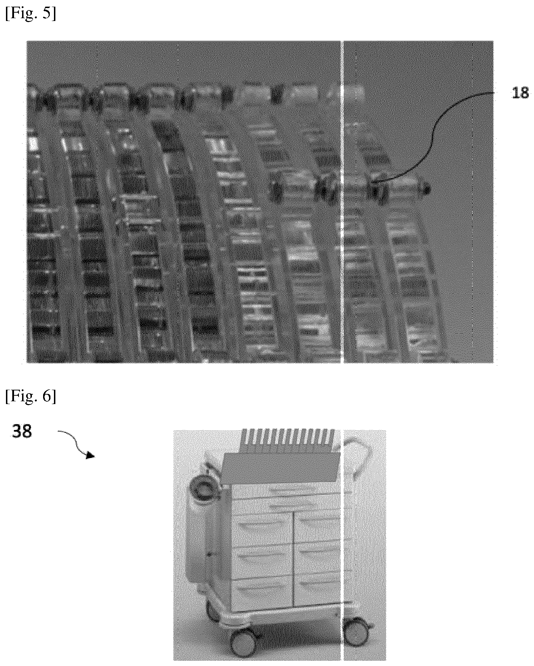

Toujours selon ce premier mode de réalisation, les moyens d'alignement comprennent des tiges filetées 15 essentiellement parallèles à l'axe principal AA' et maintenant solidaires les unes des autres les plaques support 10 ([Fig.1]). A cet égard, les plaques support 10 et les plaques de recouvrement peuvent comprendre des perçages traversés par les tiges filetées 15. Ainsi, et de manière avantageuse, chaque plaque support 10 se trouve enserrée entre les deux plaques de recouvrement par des moyens de serrage, les moyens de serrage comprenant avantageusement des écrous 18 coopérant avec les tiges filetées ([Fig.5]). Lesdits écrous 18 peuvent notamment être configurés pour maintenir l'espacement E entre les plaques support adjacentes.

L'assemblage magnétique 1A peut également comprendre au moins un passage d'alignement, par exemple deux passages d'alignement, qui s'étend parallèlement à l'axe principal AA', et de section (selon un plan parallèle à l'axe principal AA') carrée ou rectangulaire. Le passage d'alignement peut notamment être formé par une succession d'ouvertures, dites ouvertures d'alignement, traversant de part en part les plaques support 10. Il est entendu que les plaques de recouvrement 17 comprennent également des ouvertures d'alignement.

L'assemblage magnétique 1A peut également comprendre au moins une tube d'alignement 50 traversant le passage d'alignement, et présentant une forme conforme à la section dudit passage ([Fig.1]). L'au moins un tube d'alignement 50 permet de solidariser l'assemblage magnétique 1A à un chariot 38 d'un dispositif d'imagerie 1 par résonnance magnétique ([Fig.6]).

L'assemblage magnétique 1A comprend également une pluralité de pièces annulaires 19 disposées coaxialement aux sections annulaires 11, et solidaires des plaques support 10. Par exemple, les pièces annulaires 19 sont maintenues entre elles et la pluralité de plaques support par des tiges filetées, dites tiges filetées auxiliaires 21 ([Fig.3]).

Selon une première variante du premier mode de réalisation, les pièces annulaires 19 sont disposées dans le logement principal 16 ([Fig.3]).

Selon une deuxième variante du premier mode de réalisation illustrée à la [Fig.4], les pièces annulaires 19 sont disposées extérieurement au logement principal 16. Notamment, chaque pièce annulaire 19 est intercalée entre deux plaques support 10.

Chaque pièce annulaire 19 comprend deux faces, dites faces auxiliaires, et parallèles aux faces principales des plaques support 10. Des deuxièmes logements 20 sont formés dans chacune des pièces annulaires 19. Plus particulièrement, les deuxièmes logements 20 d'une pièce annulaire 19 débouchent par l'une et l'autre des faces auxiliaires de la pièce annulaire considérée.

L'assemblage magnétique 1A comprend également une deuxième pluralité d'aimants permanents. Le choix de ces aimants est laissé à l'appréciation de l'homme du métier.

Chaque aimant permanent de la deuxième pluralité d'aimants permanent est logé de manière individuelle dans les un deuxième logement.

Par ailleurs, et selon la présente invention, les pièces annulaires 19 sont agencées de manière à créer un champ magnétique secondaire dans la zone d'analyse 22 de sorte que la résultante du champ magnétique primaire et du champ magnétique secondaire, dite champ principal, dans la zone d'analyse, présente une deuxième uniformité améliorée au regard de la première uniformité.

La zone d'analyse 22 correspond à un volume interne délimité par les pièces annulaires 19.

L'agencement des aimants de la deuxième pluralité d'aimants permanents peut être déterminée par la mise en œuvre d'une méthode de simulation numérique, et plus particulièrement mettant en œuvre un algorithme génétique. L'homme du métier souhaitant mettant en œuvre un algorithme génétique pourra notamment reprendre les principes décrits dans l'article suivant : S. Binitha and S. S. Sathya, "Survey Bio inspired Optimization Algorithms", International Journal of Soft Computing and Engineering, vol. 2, issue 2, pp. 137- 151, May 2012.

Selon une variante avantageuse, les plaques support 10 comprennent des languettes internes 23 ou externes (non représentées) dans lesquelles sont formés des logements susceptibles de loger un ou plusieurs aimants permanents ([Fig.2]).

Ce dernier aspect permet également de réduire la non uniformité du champ magnétique principal dans la zone d'analyse.

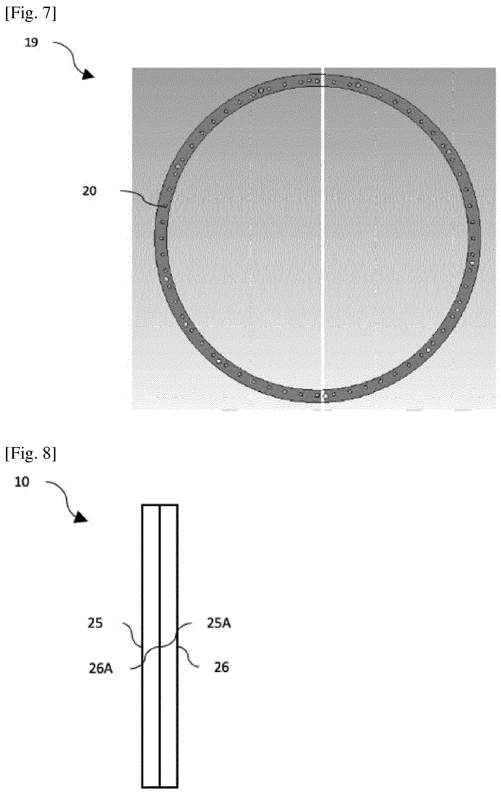

La [Fig.8] est une représentation schématique d'une plaque support 10 susceptible d'être mise en œuvre dans un deuxième mode de réalisation de la présente invention. Ce deuxième mode de réalisation reprend pour l'essentiel les principes et les termes du premier mode de réalisation.

Plus particulièrement ce deuxième mode de réalisation diffère du premier mode de réalisation en ce que la mise en œuvre des plaques de recouvrement n'est pas considérée. L'espacement E entre deux plaques support 10 adjacente est toujours considéré dans ce deuxième mode de réalisation.

Ainsi, et selon ce deuxième mode de réalisation, une plaque support 10, telle que représentée à la [Fig.8], comprend une première plaque 25 et une deuxième plaque 26.

Notamment, la première plaque 25 et la deuxième plaque 26 sont assemblées l'une contre l'autre par une face de contact. Notamment la première plaque 25 comprend une première face de contact 25A tandis que la deuxième plaque 26 comprend une deuxième face de contact 26A au contact de la première face de contact 25A. L'assemblage de la première plaque 25 avec la deuxième plaque 26 peut notamment mettre en œuvre un jeu de vis.

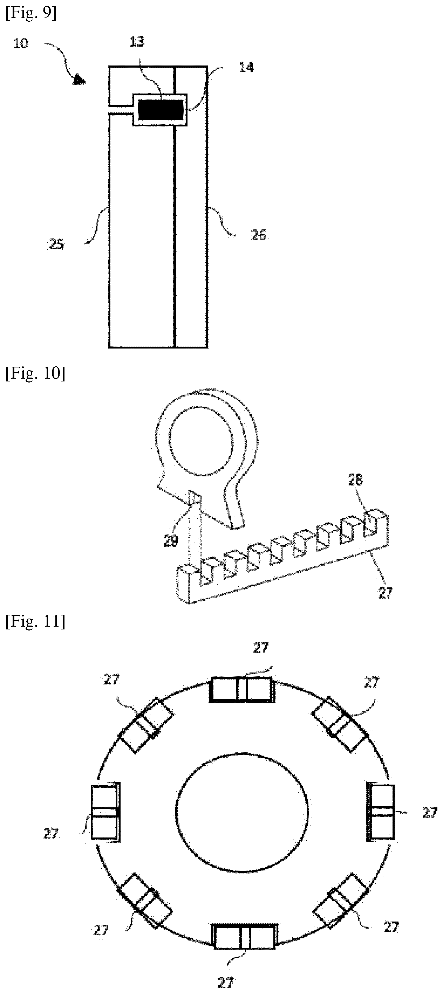

Selon ce deuxième mode de réalisation, chaque premier logement 14 est formé par une première cavité 14A et une deuxième cavité 14B formées respectivement dans la première plaque 25 et la deuxième plaque 26 ([Fig.9]).

Plus particulièrement, la première cavité 14A débouche par la première face contact 25A, tandis que la deuxième cavité 14B débouche par la deuxième face contact 26A.

Il est entendu que la face opposée à la première face contact 25A de la première plaque 25 forme une des faces principales de la plaque support, tandis que la face opposée à la deuxième face contact 26A de la deuxième plaque 26 forme l'autre des faces principales de ladite plaque support.

Selon une variante des modes de réalisation présentés ci-avant, les moyens d'alignement comprennent au moins un rail 27 pourvu d'encoches d'alignement 28 ( [Fig.10]). Chaque encoche d'alignement 28 est notamment configurée pour maintenir une plaque support 10. A cet égard, la plaque support 10 peut également comprendre une encoche, dite contre encoche d'alignement 29, configurée pour coopérer avec l'encoche d'alignement 28.

De manière avantageuse, les encoches d'alignement 28 sont configurés pour maintenir un espacement prédéterminé en deux plaques support 10 adjacentes. Par ailleurs, le rail 27 peut être fixé aux plaques support 10 avec des vis.

Tel qu'illustré à la [Fig.11], il est également possible de considérer plusieurs rails 27, distribués autour de l'assemblage magnétique 1A et maintenant l'ensemble des plaques support 10 à différentes positions angulaires autour de l'axe principal AA'.

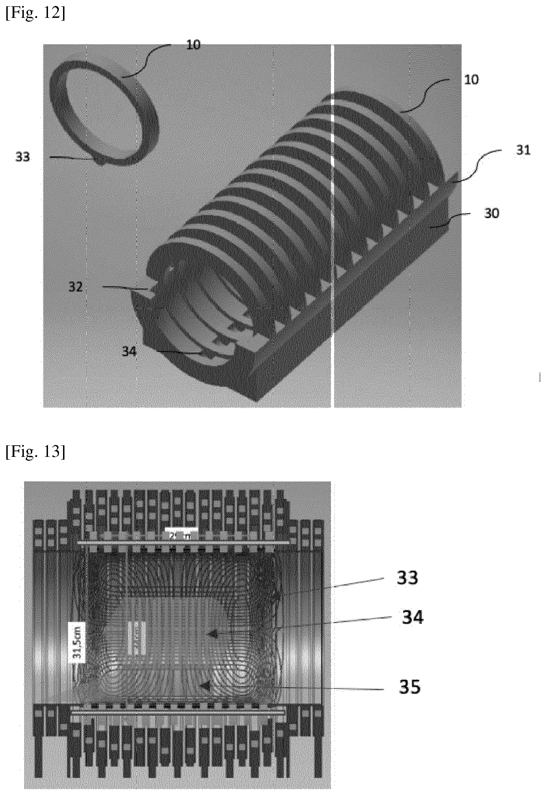

La [Fig.12] illustre une autre variante des moyens d'alignement. Notamment, les moyens d'alignement selon cette autre variante comprennent pourvu d'une embase 30 surmontée d'un berceau 31. Le berceau comprend, à cet égard, une portion de cylindre sur une surface interne de laquelle sont formées des gorges 32. Notamment chaque gorge 32 est destinée à recevoir une plaque support 10.

De manière avantageuse, chaque plaque support 10 comprend une languette externe 33 qui s'étend radialement à la section annulaire est qui est insérée dans une cavité 34 formée au fond de la gorge maintenant ladite plaque support.

Les agencements proposés dans la présente invention permettent d'assurer la cohésion globale de l'assemblage magnétique 1A. En effet, la première pluralité d'aimants, ainsi que la deuxième pluralité d'aimants, génère des forces magnétiques susceptibles de conduire à une instabilité mécanique dudit assemblage magnétique. La mise en œuvre des moyens de maintien tels que décrits dans la présente invention permet de compenser ces effets.

Par ailleurs, la considération des pièce annulaires 19 permet de compenser, au moins en partie, les inhomogénéités du champ magnétique principal imposé dans la zone d'analyse.

Quel que soit le mode de réalisation considéré, et tel qu'illustré à titre d'exemple à la [Fig.13], l'assemblage magnétique 1A peut également comprendre une bobine radiofréquence (RF) 34 et des bobines à gradient 33 maintenues par un support 35. Plus particulièrement, la bobine RF 34 et les bobines à gradient 33 sont maintenues par le support 35 dans le logement principal. De manière avantageuse, la bobine RF 34 et les bobines à gradient 33 sont interchangeables et confère également un caractère modulaire à l'assemblage magnétique 1A.

Les bobines à gradient sont configurées pour produire des champs magnétiques de petite amplitude et variant dans l'espace lorsqu'un courant leur est appliqué. Plus particulièrement, les bobines à gradient sont conçues pour produire une composante de champ magnétique qui est alignée parallèlement au champ magnétique principal, et qui varie linéairement en amplitude avec la position le long de l'un des axes x, y ou z (les axes x, y et z étant perpendiculaires deux à deux). Ainsi, les effets combinés des champ magnétiques imposés par les bobines à gradient permettent de coder spatialement chacune des positions du corps destiné à être sondé.

La bobine RF est destinée à jouer un rôle d'émetteur récepteur RF. Notamment, la bobine RF est configurée pour émettre des impulsions d'énergie RF d'une fréquence égale ou voisine de la fréquence de résonance des spins des noyaux d'hydrogène et qui est au moins en partie absorbée par ces noyaux . Dès lors que l'émission RF est interrompue, les spins nucléaires relaxent afin de retrouver leur état d'énergie initial et émettent à leur tour un signal RF susceptible d'être collecté par au moins une bobine RF. Ce signal RF est ensuite traité à l'aide d'un ordinateur et d'algorithmes de reconstruction afin d'obtenir une image du corps.

Le dispositif d'imagerie 1 selon la présente invention forme un système modulaire. Plus particulièrement, le dispositif d'imagerie 1 peut comprend au moins un premier module 36 et un deuxième module 37.

Chaque premier module 36 parmi l'au moins premier module est notamment formé par l'assemblage magnétique 1A et un chariot 38. Le chariot 38 peut comprendre des roulettes.

Le chariot 38 est notamment pourvu d'un plateau 39 sur une face, dit face supérieure, duquel est fixé l'assemblage magnétique 1A. Le chariot comprend deux parois latérales 40 et 41 supportant par un de leur bord, dit bord supérieur, le plateau 39.

Les deux parois latérales 40 et 41 délimitent avec la plateau 39, un espace d'accueil 42.

Le deuxième module 37 comprend une console, de forme essentiellement parallélépipédique, supportant un ensemble d'éléments de contrôles électroniques dudit dispositif, la console est notamment configurée pour être insérée dans l'espace d'accueil 42. La console peut à cet égard comprendre des roulettes permettant son insertion dans l'espace d'accueil.

Notamment, les flancs latéraux 43 et 44 sont en liaison glissière avec, respectivement, la paroi latérale 40 et la paroi latérale 41. A cet égard, le dispositif peut comprendre un système de glissières permettant de glissement et le verrouillage des flancs latéraux 43 et 44 contre, respectivement, la paroi latérale 40 et la paroi latérale 41. Le système de glissière peut notamment comprendre une ou deux glissières 45a, 45b. L'une ou deux glissières 45a, 45b sont à cet égard destinées à coopérer avec des rails 46a et 46b disposés sur l'une et l'autre des deux parois latérales 40 et 41. Les rails 46a et 46b peuvent par ailleurs être munis de moyens de verrouillage permettant de bloquer le deuxième module dans l'espace d'accueil 42. Les moyens de verrouillage peuvent comprendre des cales 47a et 47b.

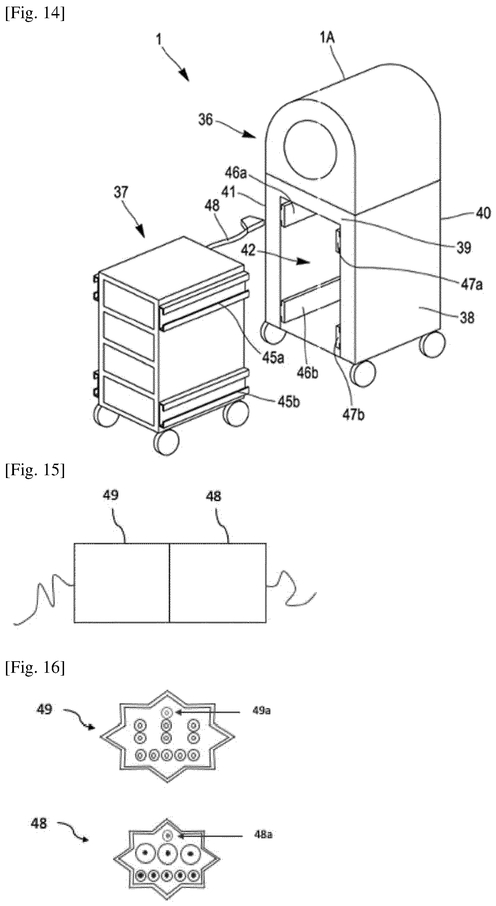

Enfin, le dispositif d'imagerie 1 comprendre également des moyens de connexion permettant de connecter le premier module 36 et le deuxième module 37. Les moyens de connexion sont notamment des moyens enfichables qui comprennent une fiche mâle 48 et une fiche femelle 49 ([Fig.14] et [Fig.15]). Notamment, la fiche male 48 est associée au deuxième module 37 tandis que la fiche femelle 36 est associée au premier module 36.

L'un et l'autre de la console et de l'au moins un premier module comprennent des moyens d'identification, par la console, des caractéristiques géométriques et magnétiques de l'assemblage magnétique dudit premier module, les moyens d'identification étant intégrés dans des moyens de connexion de la console et du premier module. Par moyens d'identification, on entend des moyens permettant à la console de reconnaitre les caractéristiques géométriques et magnétiques de l'assemblage magnétique. Cet aspect permet notamment à la console de reconnaître la configuration du dispositif d'imagerie.

Chacune des fiches mâle 48 et femelle 49, de forme complémentaire, peuvent présenter un forme en étoile ([Fig.16]). Ces dernières peuvent par ailleurs comprendre un port, dit port d'identification 48a et 49a (le port d'identification est notamment associé aux moyens d'identification), permettant d'identifier le type de premier module connecté au deuxième module.

La fonction d'identification peut faire intervenir des moyens numériques (par exemple une puce ID, e.g., RFID dans la fiche femelle et un lecteur d'ID dans le deuxième module), ou des moyens analogiques (par exemple une combinaison de résistances dans la fiche femelle, et un ampèremètre dans le deuxième module).

Les fiches mâle 48 et femelle 49 comprennent d'autres ports associés au contrôles de la bobine RF et des bobines à gradient.

Un telle configuration rend le dispositif d'imagerie 1 modulaire et permet de considérer différents assemblages magnétiques spécifiques. Notamment, il est possible selon la présente invention, de considérer différents assemblages magnétiques, chaque assemblage magnétique étant destiné à imager une partie spécifique d'un corps.

L'invention concerne un procédé de fabrication d'un assemblage magnétique d'un dispositif d'imagerie 1 par résonnance magnétique selon la présente invention, ledit procédé comprenant :
- une étape de formation des plaques support ;
- une étape de formation des pièces annulaires ;
- une étape d'assemblage des plaques support et des pièces annulaires ;

Le procédé étant caractérisé en ce que le nombre et le positionnement des pièces annulaires, ainsi que la quantité d'aimants formant chaque deuxième pluralité d'aimants, sont déterminées par la mise en œuvre d'un algorithme génétique configuré pour que la résultante du champ magnétique primaire et du champ magnétique secondaire, dite champ principal, dans la zone d'analyse, présente une deuxième uniformité soit améliorée au regard de la première uniformité.

Bien sûr, l'invention n'est pas limitée aux modes de réalisation décrits et on peut y apporter des variantes de réalisation sans sortir du cadre de l'invention tel que défini par les revendications.

## Revendications

1. Dispositif d'imagerie (1) par résonance magnétique qui comprend :
- au un moins un premier module (36), chaque premier module parmi l'au moins un premier module comprenant un chariot (38) pourvu d'un plateau (39) sur une face duquel, dite face supérieure, repose un assemblage magnétique (1A) ledit assemblage magnétique (1A) étant destiné à imposer un champ magnétique principal dans une zone d'analyse (22) d'un logement principal (16) dudit assemblage magnétique (1A), le chariot (38) comprenant en outre deux parois latérales (40, 41) supportant par un de leur bord, dit bord supérieur, le plateau (39) ;
- un deuxième module (37), pourvu d'une console, de forme essentiellement parallélépipédique, supportant un ensemble d'éléments de contrôles électroniques dudit dispositif, la console est configurée pour être insérée, par une liaison glissière, entre les parois latérales du chariot (38) de chaque premier module parmi l'au moins un premier module ;
**caractérisé en ce que**
l'un et l'autre de la console et de l'au moins un premier module comprennent des moyens d'identification, par la console, des caractéristiques géométriques et magnétiques de l'assemblage magnétique (1A) dudit premier module, les moyens d'identification étant intégrés dans des moyens de connexion de la console et du premier module.

2. Dispositif d'imagerie (1) selon la revendication 1 dans lequel l'assemblage magnétique (1A) comprend :
- une pluralité de plaques support (10) présentant chacune une section annulaire (11) délimitant une ouverture, dite ouverture support (12), lesdites plaques support (10) étant assemblées solidairement les unes des autres, par des moyens d'alignement, selon un axe principal, de sorte que les ouvertures support, alignées selon l'axe principal, délimitent le logement principal (16) de forme généralement cylindrique, chaque plaque support (10) comprend en outre une première pluralité d'aimants (13) permanents, logés dans des premiers logements (14) ménagés dans la section annulaire (11), selon au moins un agencement annulaire de Halbach autour de l'axe principal, l'ensemble des aimants de la première pluralité d'aimant créant un champ magnétique primaire dans une zone, dite zone d'analyse (22), du logement principal (16) qui présente une première uniformité ;
- une pluralité de pièces annulaires (19) assemblées coaxialement aux sections annulaires, et solidaires des plaques support (10), chaque pièce annulaire comprenant une deuxième pluralité d'aimants logées dans des deuxièmes logements (20) ménagés dans ladite pièce annulaire, l'ensemble des pièces annulaires (19) étant agencées de manière à créer un champ magnétique secondaire dans la zone d'analyse (22) de sorte que la résultante du champ magnétique primaire et du champ magnétique secondaire, dite champ principal, dans la zone d'analyse (22), présente une deuxième uniformité améliorée au regard de la première uniformité.

3. Dispositif d'imagerie (1) selon la revendication 2, dans lequel l'assemblage magnétique (1A) comprend une partie principale (2) intercalée entre deux parties secondaires (3, 4), la partie principale (2) étant formée de plaques support (10), dites plaques support principales (11A), et l'une et l'autre des parties secondaires (3, 4) étant formées de plaques support dites plaques support secondaires (11B), l'ouverture des plaques support principales (11A), dite première ouverture, présente un premier diamètre, tandis que l'ouverture des plaques support secondaires (11B), dite deuxième ouverture, présente un deuxième diamètre inférieur au premier diamètre.

4. Dispositif d'imagerie (1) selon l'une des revendications 2 ou 3, dans lequel les plaques support (10) comprennent un matériau non magnétique, avantageusement, le matériau non-magnétique comprend de l'aluminium, ou une matière plastique, par exemple du plexiglas PMMA.

5. Dispositif d'imagerie (1) selon l'une des revendications 2 à 4, dans lequel les moyens d'alignement comprennent des tiges filetées (15) essentiellement parallèles à l'axe principal et maintenant solidaires les unes des autres les plaques support (10).

6. Dispositif d'imagerie (1) selon la revendication 5, dans lequel chaque plaque support (10) se trouve enserrée entre deux plaques de recouvrement (17) par des moyens de serrage, les deux plaques de recouvrement (17) étant configurées pour retenir les aimants de la première pluralité d'aimants dans les premiers logements de la plaque support (10) considérée, les moyens de serrage comprenant avantageusement des écrous (18) coopérant avec les tiges filetées (15).

7. Dispositif d'imagerie (1) selon la revendication 6, dans lequel chaque plaque support (10) comprend une ouverture, dite ouverture d'alignement, de sorte que l'assemblage magnétique (1A) comprennent au moins un passage d'alignement de section carrée ou rectangulaire formé par les ouvertures d'alignement et qui s'étend parallèlement à l'axe principal, l'assemblage magnétique (1A) comprend en outre au moins une tube d'alignement (50) traversant le passage d'alignement, et présentant une forme conforme à la section dudit passage, ledit au moins un tube d'alignement (50) étant destiné à fixer l'assemblage magnétique (1A) au chariot (38).

8. Dispositif d'imagerie (1) selon l'une des revendications 2 à 4, dans lequel chaque plaque support (10) comprend une première plaque (25) et une deuxième plaque (26) assemblée l'une contre l'autre par une face de contact, les premiers logements (14) comprenant chacun deux cavités formées à partir de la face de contact de l'une et/ou l'autre de la première plaque (25) et de la deuxième plaque (26).

9. Dispositif d'imagerie (1) selon la revendication 8, dans lequel les moyens d'alignement comprennent au moins un rail (27) pourvu d'encoches d'alignement (28), chaque encoche d'alignement maintenant une plaque support (10), les encoches étant configurés pour maintenir un espacement prédéterminé en deux plaques support (10) adjacentes.

10. Dispositif d'imagerie (1) selon la revendication 8, dans lequel les moyens d'alignement comprennent un élément d'alignement pourvu d'une embase (30) surmontée d'un berceau (31) formant une portion de cylindre sur une surface interne de laquelle sont formées des gorges (32), chacune des plaques support (10) étant maintenue dans une gorge qui lui est propre.

11. Dispositif d'imagerie (1) selon la revendication 10, dans lequel chacune plaque support (10) comprend une languette externe qui s'étend radialement à la section annulaire (11) et qui est insérée dans une cavité formée au fond de la gorge maintenant ladite plaque support (10).

12. Dispositif d'imagerie (1) selon l'une des revendications 2 à 11, dans lequel les pièces annulaires (19) sont maintenues entre elles et la pluralité de plaques support (10) par des tiges filetées (15), dites tiges filetées (15) auxiliaires.

13. Dispositif d'imagerie (1) selon l'une des revendications 2 à 12, dans lequel les plaques support (10) comprennent des languettes internes ou externes dans lesquelles sont formés des logements susceptibles de loger un ou plusieurs aimants permanents.

14. Dispositif d'imagerie (1) selon l'une des revendications 2 à 13, dans lequel les pièces annulaires (19) sont disposées dans le logement principal (16).

15. Dispositif d'imagerie (1) selon l'une des revendications 2 à 13, dans lequel les pièces annulaires (19) sont disposées extérieurement au logement principal (16), chaque pièce annulaire est intercalée entre deux plaques support (10).

16. Dispositif d'imagerie (1) selon l'une des revendications 1 à 15, dans lequel ledit assemblage magnétique (1A) comprend en outre une bobine radiofréquence (34) et des bobines à gradients (33) disposées dans le logement principal (16) et mécaniquement solidaires de l'assemblage magnétique (1A).

17. Dispositif d'imagerie (1) selon la revendication 16, dans lequel la bobine radiofréquence et les bobines à gradients sont démontables.

## Patentansprüche

1. Bilderzeugungsvorrichtung (1) durch Magnetresonanz , die umfasst:
- mindestens ein erstes Modul (36), wobei jedes erste Modul unter dem mindestens einen ersten Modul einen Wagen (38) umfasst, der mit einer Platte (39) versehen ist, auf dessen einer Seite, der sogenannten Oberseite, eine Magnetanordnung (1A) aufliegt, wobei die Magnetanordnung (1A) dazu bestimmt ist, ein Hauptmagnetfeld in einer Analysezone (22) eines Hauptgehäuses (16) der Magnetanordnung (1A) aufzubringen, wobei der Wagen (38) außerdem zwei Seitenwände (40, 41) umfasst, die an einem ihrer Ränder, dem sogenannten oberen Rand, die Platte (39) tragen;
- ein zweites Modul (37), das mit einer im Wesentlichen parallelepipedförmigen Konsole versehen ist, die eine Gruppe von elektronischen Steuerelementen der Vorrichtung trägt, wobei die Konsole konfiguriert ist, um durch eine Gleitverbindung zwischen die Seitenwände des Wagens (38) jedes ersten Moduls unter mindestens einem ersten Modul eingeführt zu werden;
**dadurch gekennzeichnet, dass** die eine der Konsole und dem mindestens einen ersten Modul Identifizierungsmittel der geometrischen und magnetischen Merkmale der Magnetanordnung (1A) des ersten Moduls durch die Konsole umfassen, wobei die Identifizierungsmittel in Verbindungsmittel der Konsole und des ersten Moduls integriert sind.

2. Bilderzeugungsvorrichtung (1) nach Anspruch 1, in der die Magnetanordnung (1A) umfasst:
- eine Vielzahl von Trägerplatten (10), die jeweils einen ringförmigen Abschnitt (11) aufweisen, der eine Öffnung, die sogenannte Trägeröffnung (12), begrenzt, wobei die Trägerplatten (10) durch Ausrichtungsmittel entlang einer Hauptachse fest miteinander verbunden sind, so dass die Trägeröffnungen, die entlang der Hauptachse ausgerichtet sind, das Hauptgehäuse (16) in allgemein zylindrischer Form begrenzen,
jede Trägerplatte (10) weiter eine erste Vielzahl von Permanentmagneten (13) umfasst, die im ersten Gehäuse (14) aufgenommen sind, die in dem ringförmigen Abschnitt (11) ausgebildet sind, gemäß mindestens einer ringförmigen Halbach-Anordnung um die Hauptachse, wobei die Gesamtheit der Magnete der ersten Mehrzahl von Magneten ein primäres Magnetfeld in einem Bereich, dem sogenannten Analysebereich (22), des Hauptgehäuses (16) erzeugt, das eine erste Gleichförmigkeit aufweist ;
- eine Vielzahl von ringförmigen Teilen (19), die koaxial zu den ringförmigen Abschnitten angeordnet und fest mit den Trägerplatten (10) verbunden sind, wobei jedes ringförmige Teil eine zweite Vielzahl von Magneten umfasst, die im zweiten Gehäuse (20) aufgenommen sind, die in dem ringförmigen Teil ausgebildet sind, wobei die Gesamtheit der ringförmigen Teile (19) so angeordnet ist, dass sie ein sekundäres Magnetfeld in der Analysezone (22) erzeugt, so dass die Resultierende des primären Magnetfelds und des sekundären Magnetfelds, das sogenannte Hauptfeld, in der Analysezone (22) eine zweite Gleichförmigkeit aufweist, die im Hinblick auf die erste Gleichförmigkeit verbessert ist.

3. Bilderzeugungsvorrichtung (1) nach Anspruch 2, wobei die Magnetanordnung (1A) einen Hauptteil (2) umfasst, der zwischen zwei Sekundärteilen (3, 4) eingefügt ist, wobei der Hauptteil (2) aus Trägerplatten (10) gebildet ist, die als Hauptträgerplatten (11A) bezeichnet werden, und beide der sekundären Teile (3, 4) aus Trägerplatten, den sogenannten sekundären Trägerplatten (11B), gebildet sind, wobei die Öffnung der Hauptträgerplatten (11A), die sogenannte erste Öffnung, einen ersten Durchmesser aufweist, während die Öffnung der sekundären Trägerplatten (11B), die sogenannte zweite Öffnung, einen zweiten Durchmesser aufweist, der kleiner als der erste Durchmesser ist.

4. Bilderzeugungsvorrichtung (1) nach einem der Ansprüche 2 oder 3, wobei die Trägerplatten (10) ein nicht-magnetisches Material umfassen, vorteilhafterweise das nicht-magnetische Material Aluminium, oder einen Kunststoff, z. B. PMMA-Plexiglas umfasst.

5. Bilderzeugungsvorrichtung (1) nach einem der Ansprüche 2 bis 4, wobei die Ausrichtungsmittel Gewindestangen (15) umfassen, die im Wesentlichen parallel zur Hauptachse verlaufen und die Trägerplatten (10) fest miteinander verbinden.

6. Bilderzeugungsvorrichtung (1) nach Anspruch 5, wobei jede Trägerplatte (10) durch Klemmmittel zwischen zwei Deckplatten (17) eingeklemmt ist, die beiden Deckplatten (17) so gestaltet sind, dass sie die Magnete der ersten Vielzahl von Magneten in dem ersten Gehäuse der betreffenden Trägerplatte (10) festhalten, wobei die Klemmmittel vorteilhafterweise Muttern (18) umfassen, die mit den Gewindestangen (15) zusammenwirken.

7. Bilderzeugungsvorrichtung (1) nach Anspruch 6, wobei jede Trägerplatte (10) eine Öffnung, die Ausrichtungsöffnung genannt wird, umfasst, so dass die Magnetanordnung (1A) mindestens einen Ausrichtungsdurchgang mit quadratischem oder rechteckigem Querschnitt umfasst, der durch die Ausrichtungsöffnungen gebildet wird und sich parallel zur Hauptachse erstreckt, wobei die Magnetanordnung (1A) weiter mindestens ein Ausrichtungsrohr (50) umfasst, das durch den Ausrichtungsdurchgang verläuft und eine Form aufweist, die mit dem Querschnitt des Durchgangs übereinstimmt, wobei das mindestens eine Ausrichtungsrohr (50) dazu dient, die Magnetanordnung (1A) am Schlitten (38) zu befestigen.

8. Bilderzeugungsvorrichtung (1) nach einem der Ansprüche 2 bis 4, wobei jede Trägerplatte (10) eine erste Platte (25) und eine zweite Platte (26) umfasst, die über eine Kontaktfläche miteinander verbunden sind, wobei das erste Gehäuse (14) jeweils zwei Hohlräume umfassen, die von der Kontaktfläche der einen und/oder der anderen der ersten Platte (25) und der zweiten Platte (26) gebildet werden.

9. Bilderzeugungsvorrichtung (1) nach Anspruch 8, wobei die Ausrichtungsmittel mindestens eine Schiene (27) umfassen, die mit Ausrichtungskerben (28) versehen ist, wobei jede Ausrichtungskerbe eine Trägerplatte (10) hält, wobei die Kerben konfiguriert sind, um einen vorbestimmten Abstand zwischen zwei benachbarten Trägerplatten (10) aufrechtzuerhalten.

10. Bilderzeugungsvorrichtung (1) nach Anspruch 8, wobei die Ausrichtungsmittel ein Ausrichtelement umfassen, das mit einer Basis (30) versehen ist, über der sich eine Wiege (31) befindet, die einen Zylinderabschnitt bildet, auf dessen Innenfläche Nuten (32) ausgebildet sind, wobei jede der Trägerplatten (10) in einer ihr eigenen Nut gehalten wird.

11. Bilderzeugungsvorrichtung (1) nach Anspruch 10, wobei jede Trägerplatte (10) eine äußere Zunge umfasst, die sich radial zu dem ringförmigen Abschnitt (11) erstreckt und die in einen Hohlraum eingesetzt ist, der an dem Boden der Nut ausgebildet ist, die die Trägerplatte (10) hält.

12. Bilderzeugungsvorrichtung (1) nach einem der Ansprüche 2 bis 11, wobei die ringförmigen Teile (19) zwischen ihnen und der Vielzahl von Trägerplatten (10) durch Gewindestangen (15), sogenannte Hilfsgewindestangen (15), gehalten werden.

13. Bilderzeugungsvorrichtung (1) nach einem der Ansprüche 2 bis 12, wobei die Trägerplatten (10) innere oder äußere Zungen umfassen, in denen Gehäuse ausgebildet sind, die einen oder mehrere Permanentmagneten aufnehmen können.

14. Bilderzeugungsvorrichtung (1) nach einem der Ansprüche 2 bis 13, wobei die ringförmigen Teile (19) in dem Hauptgehäuse (16) angeordnet sind.

15. Bilderzeugungsvorrichtung (1) nach einem der Ansprüche 2 bis 13, wobei die ringförmigen Teile (19) außerhalb des Hauptgehäuses (16) angeordnet sind, wobei jedes ringförmige Teil zwischen zwei Trägerplatten (10) eingefügt ist.

16. Bilderzeugungsvorrichtung (1) nach einem der Ansprüche 1 bis 15, wobei die Magnetanordnung (1A) weiter eine Hochfrequenzspule (34) und Gradientenspulen (33) umfasst, die in dem Hauptgehäuse (16) angeordnet und mechanisch fest mit der Magnetanordnung (1A) verbunden sind.

17. Bilderzeugungsvorrichtung (1) nach Anspruch 16, wobei die Hochfrequenzspule und die Gradientenspulen demontierbar sind.

## Claims

1. A magnetic resonance imaging device (1) comprising:
- at least one first module (36), each first module among the at least one first module comprising a carriage (38) provided with a plate (39) on one face thereof, referred to as the upper face, a magnetic assembly (1A) rests, said magnetic assembly (1A) being intended to impose a main magnetic field in an analysis area (22) of a main housing (16) of said magnetic assembly (1A), the carriage (38) further comprising two side walls (40, 41) supporting the plate (39) by one of their edges, referred to as the upper edge;
- a second module (37), provided with a console, essentially parallelepiped in shape, supporting a set of electronic control elements of said device, the console is configured to be inserted, by a slide connection, between the side walls of the carriage (38) of each first module among the at least one first module;
**characterised in that** both of the console and the at least one first module comprise means for identifying, by the console, geometric and magnetic characteristics of the magnetic assembly (1A) of said first module, the identification means being integrated into means for connecting the console and the first module.

2. The imaging device (1) according to claim 1, wherein the magnetic assembly (1A) comprises:
- a plurality of support sheets (10) each having an annular section (11) delimiting an opening, referred to as the support opening (12), said support sheets (10) being assembled integrally with one another, by means of alignment means, along a main axis, so that the support openings, aligned along the main axis, delimit the main housing (16) generally cylindrical in shape,
each support sheet (10) further comprises a first plurality of permanent magnets (13), accommodated in first housings (14) formed in the annular section (11),
according to at least one Halbach annular arrangement around the main axis, all of the magnets of the first plurality of magnets creating a primary magnetic field in an area, referred to as the analysis area (22), of the main housing (16) which has a first uniformity;
- a plurality of annular parts (19) assembled coaxially with the annular sections, and secured to the support sheets (10), each annular part comprising a second plurality of magnets accommodated in second housings (20) formed in said annular part,
all of the annular parts (19) being arranged so as to create a secondary magnetic field in the analysis zone (22) so that the resultant of the primary magnetic field and of the secondary magnetic field, referred to as the main field, in the analysis area (22), has a second uniformity improved compared to the first uniformity.

3. The imaging device (1) according to claim 2, wherein the magnetic assembly (1A) comprises a main portion (2) interposed between two secondary portions (3, 4), the main portion (2) being formed of support sheets (10), referred to as the main support sheets (11A), and both of the secondary parts (3, 4) being formed of support sheets referred to as the secondary support sheets (11B), the opening of the main support sheets (11A), referred to as the first opening, has a first diameter, whereas the opening of the secondary support plates (11B), referred to as the second opening, has a second diameter smaller than the first diameter.

4. The imaging device (1) according to one of claims 2 or 3, wherein the support sheets (10) comprise a non-magnetic material, advantageously the non-magnetic material comprises aluminium, or a plastic material, for example PMMA plexiglass.

5. The imaging device (1) according to one of claims 2 to 4, wherein the alignment means comprise threaded rods (15) essentially parallel to the main axis and holding the support sheets (10) integral with each other.

6. The imaging device (1) according to claim 5, wherein each support sheet (10) is clamped between two cover sheets (17) by clamping means, the two cover sheets (17) being configured to hold the magnets of the first plurality of magnets in the first housings of the considered support sheet (10), the clamping means advantageously comprising nuts (18) cooperating with the threaded rods (15).

7. The imaging device (1) according to claim 6, wherein each support sheet (10) comprises an opening, referred to as the alignment opening, so that the magnetic assembly (1A) comprises at least one alignment passage with a square or rectangular section formed by the alignment openings and which extends parallel to the main axis, the magnetic assembly (1A) further comprises at least one alignment tube (50) passing through the alignment passage, and having a shape conforming to the section of said passage, said at least one alignment tube (50) being intended to fasten the magnetic assembly (1A) to the carriage (38).

8. The imaging device (1) according to one of claims 2 to 4, wherein each support sheet (10) comprises a first sheet (25) and a second sheet (26) assembled against one another by a contact face, each of the first housings (14) comprising two cavities formed from the contact face of either one or both of the first sheet (25) and the second sheet (26).

9. The imaging device (1) according to claim 8, wherein the alignment means comprise at least one rail (27) provided with alignment notches (28), each alignment notch holding a support sheet (10), the notches being configured to keep a predetermined spacing at two adjacent support sheets (10).

10. The imaging device (1) according to claim 8, wherein the alignment means comprise an alignment element provided with a base (30) topped by a cradle (31) forming a cylinder portion over an inner surface of which grooves (32) are formed, each of the support sheets (10) being held in a groove that is specific thereto.

11. The imaging device (1) according to claim 10, wherein each support sheet (10) comprises an outer tab which extends radially to the annular section (11) and which is inserted into a cavity formed at the bottom of the groove holding said support sheet (10).

12. The imaging device (1) according to one of claims 2 to 11, wherein the annular parts (19) are held together and with the plurality of support sheets (10) by threaded rods (15), referred to as the auxiliary threaded rods (15).

13. The imaging device (1) according to one of claims 2 to 12, wherein the support sheets (10) comprise inner or outer tabs in which housings capable of accommodating one or more permanent magnets are formed.

14. The imaging device (1) according to one of claims 2 to 13, wherein the annular parts (19) are arranged in the main housing (16).

15. The imaging device (1) according to one of claims 2 to 13, wherein the annular parts (19) are arranged externally to the main housing (16), each annular part is interposed between two support sheets (10).

16. The imaging device (1) according to one of claims 1 to 15, wherein said magnetic assembly (1A) further comprises a radio-frequency coil (34) and gradient coils (33) arranged in the main housing (16) and mechanically secured to the magnetic assembly (1A).

17. The imaging device (1) according to claim 16, wherein the radio-frequency coil and the gradient coils are detachable.
